Europäisches Patentamt

European Patent Office

Office européen des brevets

(11) Veröffentlichungsnummer: **0 214 523**
**A2**

(12) **EUROPÄISCHE PATENTANMELDUNG**

(21) Anmeldenummer: **86111537.6**

(22) Anmeldetag: **20.08.86**

(51) Int. Cl.⁴: **G 11 C 27/02**

(30) Priorität: **09.09.85 CH 3875/85**

(43) Veröffentlichungstag der Anmeldung:
**18.03.87 Patentblatt 87/12**

(84) Benannte Vertragsstaaten:
**AT BE CH DE FR GB IT LI NL SE**

(71) Anmelder: **Willi Studer AG, Fabrik für elektronische Apparate**
**Althardstrasse 30**
**CH-8105 Regensdorf ZH(CH)**

(72) Erfinder: **Thie, Werner**
**Seidenstrasse 18**
**CH-8400 Winterthur(CH)**

(72) Erfinder: **Schmid, Johann Jakob**
**Rosengartenstrasse 33**
**CH-8107 Buchs ZH(CH)**

(54) Vorrichtung zur Digitalisierung von Messignalen.

(57) Bei einer solchen Vorrichtung mit einem Bandbegrenzungsfilter (15, 16, 17), einem Abtast- und Halteglied (21, 22, 23) und einem Analog/Digital-Wandler (39) in Serieschaltung, ist das Bandbegrenzungsfilter als Filter mit geschalteten Kapazitaeten ausgebildet und an eine Taktsignalquelle (31) mit veraenderbarer Frequenz angeschlossen. Dies erlaubt es auf einfache Weise die Abtastfrequenz fuer die digitale Verarbeitung der Signale zu veraendern.

Croydon Printing Company Ltd.

EP 0 214 523 A2

------------------------------------------------

Die Erfindung betrifft eine Vorrichtung zur Digitalisierung von Messsignalen mit einer Serieschaltung eines Bandbegrenzungsfilters, eines Abtast- und Haltegliedes und eines Analog-/Digital-Wandlers.

Fuer die bisher bekannte Digitalisierung insbesondere physiologischer Messsignale werden die analog anfallenden Messsignale mit einer festen Abtastfrequenz digitalisiert. Die Abtast- und Halteglieder arbeiten mit dieser festen Abtastfrequenz und das Bandbegrenzungsfilter ist durch die Dimension seiner Elemente auf diese Abtastfrequenz abgestimmt.

Um auf diese bekannte Weise eine Digitalisierung der Messwerte mit verschiedenen Abtastfrequenzen durchzufuehren, muessen mehrere Filter vorgesehen werden, von denen jedes auf eine bestimmte Abtastfrequenz eingestellt ist, und wobei jedes nach Bedarf zu- oder wegschaltbar ist. Dies ergibt einen hohen Schaltungsaufwand und ermoeglicht dabei nur die Verwendung einzelner diskreter Abtastfrequenzen. Die Wahl der gewuenschten Abtastfrequenzen hat deshalb bei der Auslegung der Filter zu erfolgen und kann nachtraeglich nicht mehr leicht geaendert werden.

Die Erfindung wie sie in den Anspruechen gekennzeichnet ist, loest die Aufgabe eine Vorrichtung zu schaffen, mit der auf einfache Weise die Messsignale mit wechselnden Abtastfrequenzen digitalisiert und verarbeitet werden koennen.

Die durch die Erfindung erreichten Vorteile sind im wesentlichen darin zu sehen, dass eine Verminderung des Datenstromes fuer die Auswertung der Messsignale erreicht werden kann. Dies, weil die erfindungsgemaesse Vorrichtung es erlaubt wenig interessierende Bereiche eines Messsignales mit tiefer Abtastfrequenz, wichtige Bereiche dagegen mit hoher Abtastfrequenz zu digitalisieren. Dies ergibt fuer die wichtigen, aber nur fuer die wichtigen Signalabschnitte eine grosse

Aufloesung und spart Verarbeitungszeit bei den unwesentlichen Signalabschnitten. Dies ermoeglicht es mit demselben Geraet sowohl Langzeitmessungen, bei geringer Datendichte, als auch Teilbereichsmessungen mit hoher Datendichte durchzufuehren.

Im folgenden wird die Erfindung anhand von lediglich einen Ausfuehrungsweg darstellenden Zeichnungen naeher erlaeutert. Es zeigt

Figur 1 ein Blockschema der erfindungsgemaessen Vorrichtung,
Figur 2 ein einfaches Beispiel fuer ein Bandbegrenzungsfilter,
Figur 3 eine schematische Darstellung eines Messsignales und
Figur 4 eine schematische Darstellung eines Teils der Vorrichtung.

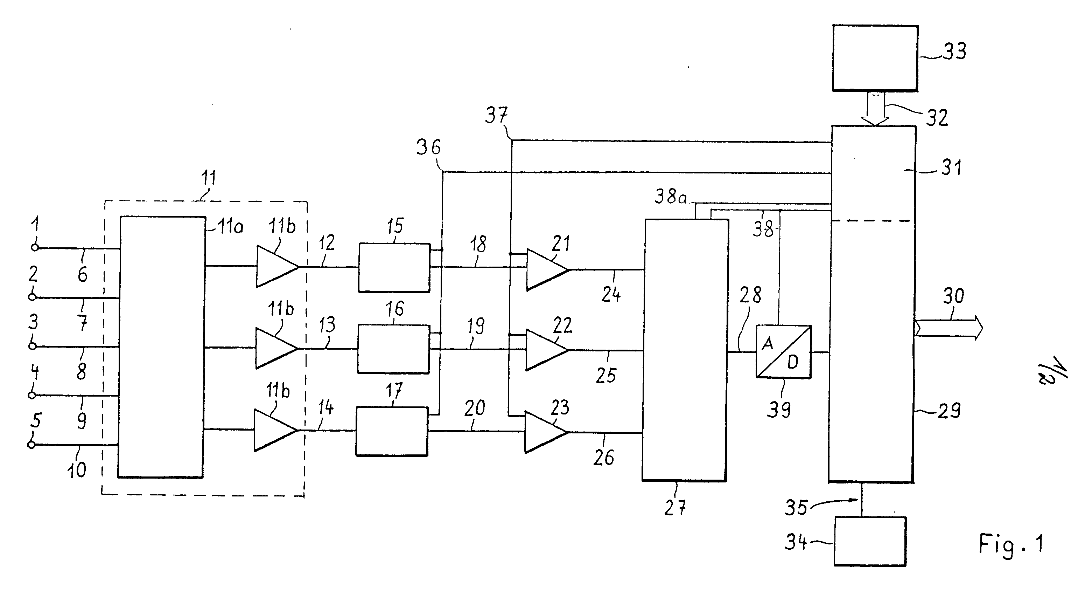

Das Blockschema gemaess Figur 1, zeigt einen Teil einer Vorrichtung zur Verarbeitung von physiologischen Messsignalen, wie sie beispielsweise in der Umgebung des Herzens eines Lebewesens abgegriffen werden koennen. Deshalb sind Elektroden 1, 2, 3, 4 und 5 ueber Leitungen 6, 7, 8, 9 und 10 an eine Eingangsverstaerkergruppe 11 angeschlossen. Solche Eingangsverstaerkergruppen sind an sich bekannt und dienen der Bildung von sogenannten Ableitungen oder Differenzen zwischen den Signalen aus je zwei Elektroden. Die Eingangsverstaerkergruppe 11 besteht aus einer Signaldifferenzbildungsschaltung 11a und aus daran angeschlossenen Verstaerkern 11b. Leitungen 12, 13 und 14 verbinden die Eingangsverstaerkergruppe 11 mit je einem Bandbegrenzungsfilter 15, 16 und 17. Ueber Leitungen 18, 19 und 20 sind die Bandbegrenzungsfilter 15, 16 und 17 an je ein Abtast- und Halteglied 21, 22 und 23 angeschlossen. Deren Ausgaenge sind ueber Leitungen 24, 25 und 26 mit einem Multiplexer 27 verbunden, der ueber eine Leitung 28 und einen Analog/Digital-Wandler 39 mit einem Rechner 29 verbunden ist. Als Ausgang weist der Rechner 29 einen Bus 30 auf. Als Taktsignalquelle fuer die Bandbegrenzungsfilter 15, 16 und 17 ist eine Zeitsteuerung 31 vorgesehen. Sie kann als Teil des Rechners 29 aufgefasst werden. Ueber einen Bus 32 ist der Rechner 29 mit einer Eingabeeinheit 33 verbunden. Ferner ist ein Quarz 34 ueber eine Leitung 35 an den Rechner 29 angeschlossen. Zur Uebertragung von Taktsignalen von der Zeitsteuerung 31 an die Bandbegrenzungsfilter 15, 16 und 17, an die Abtast- und Halteglieder 21, 22 und 23, an den Multiplexer 27, sowie an den Analog/Digital-Wandler 39 sind Leitungen 36, 37, 38 und 38a vorgesehen.

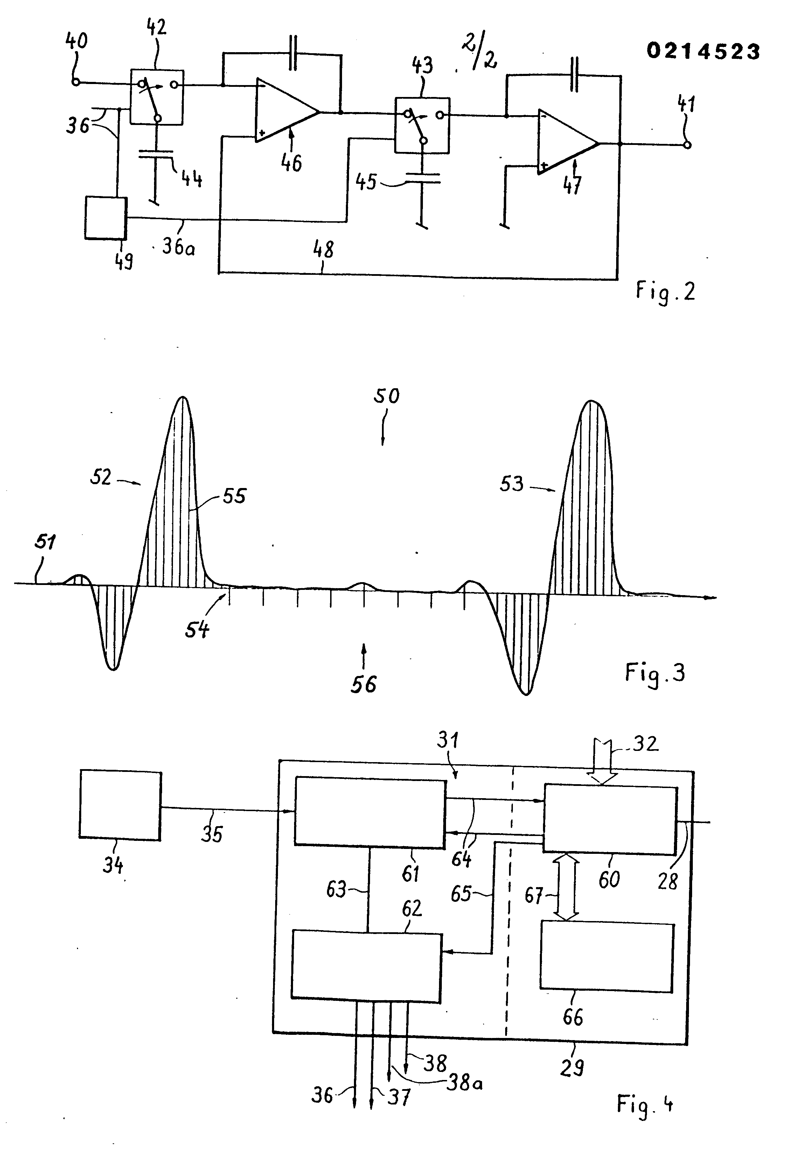

Figur 2 zeigt ein an sich bekanntes Filter mit geschalteten Kondensatoren. Es ist ein Filter zweiter Ordnung mit Tiefpasscharakteristik. Es weist je einen Eingang 40 und einen Ausgang 41 sowie ueber Schalter 42 und 43 geschaltete Kondensatoren 44 und 45 auf. Vorzugsweise sind die Schalter 42 und 43 in Halbleitertechnik realisiert. Den Schaltern 42 und 43 nachgeschaltet ist je ein Integrator 46 und 47, die zudem ueber eine Rueckkopplung 48 miteinander verbunden sind. Der Schalter 42 ist an die Leitung 36 angeschlossen, waehrend der Schalter 43 ueber ein Verzoegerungsglied 49 und eine Leitung 36a an die Leitung 36 angeschlossen ist. Die Taktsignale aus der Leitung 36 werden im Verzoegerungsglied 49 um einen Bruchteil einer Taktperiode verzoegert.

Figur 3 zeigt ein Messsignal 50 das ueber einer Zeitachse 51 aufgetragen ist. Das Messsignal 50 stellt beispielsweise eine Ableitung der Signale eines menschlichen Herzens in einer Ebene dar. Dabei erkennt man zwei Signalabschnitte 52 und 53 die als QRS-Komplexe der Fachwelt allgemein bekannt sind. Auf der Zeitachse 51 sind Abtastzeitpunkte 54 eingezeichnet, die angeben, zu welchen Zeiten ein Abtastwert aus dem Messsignal ermittelt wird. Solche Abtastwerte sind durch Linien 55 dargestellt.

Figur 4 zeigt nochmals schematisch den Quarz 34 der ueber eine Leitung 35 an den Rechner 29 angeschlossen ist. Der Rechner 29 weist dabei neben einem Mikroprozessor 60 einen Generator 61 und einen Frequenzteiler 62 auf. Leitungen 36, 37, 38 und 38a bilden Ausgaenge aus dem Frequenzteiler 62. Der Generator 61 und der Frequenzteiler 62 bilden zusammen die Zeitsteuerung oder Taktfrequenzquelle 31. Dabei ist der Generator 61 ueber eine Leitung 63 mit dem Frequenzteiler 62 und ueber weitere Leitungen 64 mit dem Mikroprozessor 60 verbunden. Eine Leitung 65 verbindet diesen mit dem Frequenzteiler 62. Der Bus 32 ist an den Mikroprozessor 60 angeschlossen. Der Mikroprozessor 60 ist ferner ueber einen Bus 67 mit einem Speicher 66 verbunden, der vorzugsweise als RAM ausgebildet ist. Ebenso ist der Mikroprozessor 60 an die Leitung 28 angeschlossen, so dass ihm alle Abtastwerte zugefuehrt werden koennen.

Der Quarz 34 gibt ueber die Leitung 35 eine sehr hochfrequente Schwingung im Megahertzbereich an den Generator 61 ab. Dieser formt diese sinusfoermige Schwingung in eine Folge von Rechteckimpulsen um, die ueber die Leitung 63 dem Frequenzteiler 62 zugefuehrt werden. Die Frequenz der Impulse in der Leitung 63 wird im Frequenzteiler 62 durch Faktoren $2^l$ oder $2^i$ geteilt. Dabei gilt $2^l = k \cdot 2^i$. k kann beliebige ganze Zahlen annehmen. Die durch $2^i$ geteilte Frequenz wird ueber die Leitung 36 abgegeben. Die durch $2^l$ geteilte Frequenz wird ueber die Leitung 37 abgegeben. Somit unterscheiden sich die Frequenzen der Taktsignale in den Leitungen 36 und 37 um den Faktor k. Ueber die Leitungen 38 und 38a koennen noch weitere Taktsignale mit anderen Frequenzen abgegeben werden. Ueber die Leitung 65 kann der Mikroprozessor 60 die Werte fuer die Faktoren l, i und k an den Frequenzteiler 62 abgeben. Ueber die Leitungen 64 gibt der Generator 61 auch Taktsignale an den Mikroprozessor 60 ab, der diese fuer seine Arbeit braucht. Ebenso empfaengt der Generator 61 ueber diese Leitung 64 Start- und Stopsignale.

Die Elektroden 1, 2, 3, 4 und 5 liefern analoge Signale zum Beispiel in der Form elektrischer Spannungen. In der Signaldifferenzbildungsschaltung 11a werden aus den Signalen von je zwei der Leitungen 6, 7, 8, 9 oder 10 Signaldifferenzen gebildet, die anschliessend in den Verstaerkern 11b verstaerkt werden. Dies ergibt in den Leitungen 12, 13 und 14 analoge Signale welche in den Bandbegrenzungsfiltern 15, 16 und 17 von allfaelligen hochfrequenten Signalteilen befreit werden, um spaeter deren Rueckfaltung in den Frequenzbereich der Nutzsignale zu vermeiden, wie dies bei der Digitalisierung von Signalen unter der Bezeichnung "Aliasing" bekannt ist. Solche Bandbegrenzungsfilter lassen sich als passive Filter (bestehend aus Widerstaenden, Kapazitaeten und Induktivitaeten) aber auch als aktive Filter (mit Operationsverstaerkern statt Induktivitaeten) ausbilden. Besonders guenstig ist es aber solche Bandbegrenzungsfilter als Filter mit Abtastung analoger Eingangswerte auszubilden. Bei diesen Filtern werden die analog anfallenden Eingangswerte zuerst mit einer bestimmten Abtastfrequenz abgetastet. Die so gewonnenen Abtastwerte werden dann so weiter verarbeitet, dass die gewuenschte Filterfunktion fuer die integrierten Ausgangsabtastwerte des Filters erfuellt ist. Ein Beispiel solcher Filter sind die Filter mit geschalteten Kapazitaeten (SC-Filter). Bei diesen sind die Widerstaende durch Kapazitaeten ersetzt, die durch Schaltelemente zu- und weggeschaltet werden koennen. Als Beispiel eines solchen Filters sei der Typ MF6CN der Firma National Semiconductors genannt.

Beim Betrieb der erfindungsgemaessen Vorrichtung erhalten die Bandbegrenzungsfilter 15, 16 und 17 Taktsignale aus der Zeitsteuerung 31 ueber Leitung 36. Diese Taktsignale bestimmen die Frequenz mit welcher die Schalter 42, 43 in den Bandbegrenzungsfiltern 15, 16 und 17 betaetigt werden. Das bedeutet einerseits, dass die Signale die am Eingang 40 des Filters anliegen mit dieser Frequenz abgetastet werden und andererseits, dass der Frequenzgang der Bandbegrenzungsfilter 15, 16 und 17 eine bestimmte, dieser Frequenz zugeordnete Charakteristik aufweist. Beispielsweise gilt fuer das obengenannte Tiefpass-Filter MF6CN, dass das Verhaeltnis der Taktfrequenz zur Frequenz eines Signales die nicht mehr uebertragen wird, also zur oberen Grenzfrequenz 50 zu 1 betraegt. Die Abtastfrequenz andererseits soll mindestens doppelt so hoch sein wie diese Grenzfrequenz (lowpass cutoff frequency). Wollen wir somit beispielsweise die physiologischen Messsignale mit einer Abtastfrequenz von 500 Hz abtasten, so muessen die analogen Eingangssignale in den Leitungen 12, 13 und 14, gemaess dem Sampling-Theorem von Shannon so gefiltert werden, dass Frequenzanteile mit einer Frequenz groesser als 250 Hz vollstaendig unterdrueckt sind. Damit dies durch die Bandbegrenzungsfilter 15, 16, 17 auch geschieht, muss die Zeitschaltung 31 ueber die Leitung 36 Taktsignale mit einer Frequenz von 12,5 kHz abgeben. Fuer dieses Beispiel gilt somit: k=25.

Eine weitere Taktfrequenz wird durch Taktsignale in der Leitung 37 an die Abtast- und Halteglieder 21, 22 und 23 angelegt. Fuer unser Beispiel betraegt diese Taktfrequenz 500 Hz. Sie entspricht also der gewuenschten Abtastfrequenz. Gemaess dieser Taktfrequenz werden die Signale in die Leitungen 24, 25 und 26 abgegeben und dem Multiplexer 27 zugefuehrt. Dieser ist durch Taktsignale aus den Leitungen 38 und 38a angesteuert. Da der Multiplexer 27 durch drei Leitungen 24, 25 und 26 angespiesen wird muss, seine Taktfrequenz mindestens dreimal so hoch sein wie die Abtastfrequenz. Dies trifft fuer die Taktfrequenz in der Leitung 38, die auch dem Analog/Digital-Wandler 39 zugefuehrt wird, zu. Das Taktsignal in der Leitung 38a hat eine Frequenz, die um einen bestimmten Faktor gegenueber der Taktfrequenz aus der Leitung 38 verringert ist. In unserem Beispiel mit den drei Leitungen 24, 25 und 26 die an den Multiplexer 27 angeschlossen sind, betraegt dieser Faktor 2/3. Mit den beiden Taktsignalen aus den Leitungen 38 und 38a kann der Multiplexer 27 seine Arbeit in an sich bekannter Weise ausfuehren. Die multiplexierten Abtastwerte gelangen dann ueber Leitung 28 in den Analog/Digital-Wandler 39, wo sie in bekannter Weise gewandelt werden. Anschliessend werden sie dem Rechner 29 zugefuehrt, der diese Werte weiterverarbeitet.

Ueber die Eingabeeinheit 33 kann die Zeitschaltung 31 veranlasst werden, die Frequenz der auszugebenden Taktsignale zu aendern. Dies ergibt in den Bandbegrenzungsfiltern 15, 16 und 17 und in den Abtast- und Haltegliedern 21, 22, 23 andere Abtastfrequenzen. Das Verhaeltnis der Frequenzen in den Leitungen 36, 37 und 38 bleibt aber erhalten. Mit der Veraenderung der Frequenz des Taktsignales in der Leitung 36, veraendert sich ebenfalls die obere Grenzfrequenz der Bandbegrenzungsfilter 15, 16 und 17 entsprechend. Durch zeitlich variable Steuerung der Taktfrequenzen kann, wie dies aus Figur 3 bekannt ist, bestimmten Signalabschnitten 52, 53 eine hoehere Taktfrequenz zugeordnet werden. Dies ergibt eine groessere Anzahl Messwerte die eine genauere Auswertung ermoeglichen. In anderen Signalabschnitten (wie 56) kann eine tiefe Abtastfrequenz genuegen. Solche Signalabschnitte 52, 53, 56 koennen beispielsweise in den Rechner 29 mit Anfangs- und Endzeiten eingegeben werden. Die Anfangs- und Endzeiten werden ueber die Eingabeeinheit 33 eingegeben und im Speicher 66 gespeichert. Diese Anfangs- und Endzeiten werden vorzugsweise bezogen auf einen Referenzpunkt im Signalverlauf angegeben. Ein solcher Referenzpunkt ist aus der europaeischen Patentanmeldung O 150 352 bekannt. Der Anfang- und das Ende solcher Signalabschnitte kann aber auch von den Werten der vorkommenden Abtastwerte abhaengig gemacht werden in dem Sinne, dass Schwellwerte vorgegeben werden, die eine andere Taktfrequenz ueber den Rechner 29 ausloesen, sobald Abtastwerte diese Schwellwerte erreichen. Diese Schwellwerte werden ebenfalls ueber die Eingabeeinheit 33 eingegeben und im Speicher 66 gespeichert. Die Abtastwerte die ueber die Leitung 28 in den Mikroprozessor 60 gelangen, werden dort laufend mit den Schwellwerten verglichen. Erreichen die Abtastwerte einen Schwellwert, so gibt der Mikroprozessor neue Werte fuer l, i und k an den Frequenzteiler 62 ueber die Leitung 65 ab. Dementsprechend werden die Taktfrequenzen in den Leitungen 36, 37 und 38 veraendert.

Zur Ausfuehrung einer solchen Vorrichtung koennen Bauteile des Typs 63B03 fuer den Rechner 29, des Typs ADC1001 fuer den Analog/Digital-Wandler 39, des Typs CD4051 fuer den Multiplexer 27, des Typs LF198 fuer die Abtast-und Halteglieder 21, 22 und 23, des Typs TL064 fuer die Signaldifferenzbildungsschaltung 11a und des Typs TL064 fuer die Verstaerker 11b verwendet werden.

00 Patentansprueche:                                    **0214523**

1. Vorrichtung zur Digitalisierung von Messignalen, mit einer Serieschaltung eines Bandbegrenzungsfilters (15, 16, 17), eines Abtast- und Haltegliedes (21, 22, 23) und eines Analog-/Digital-Wandlers (39), dadurch gekennzeichnet, dass das Bandbegrenzungsfilter (15, 16, 17) als Filter mit Abtastung analoger Eingangswerte ausgebildet und an eine Taktsignalquelle (31) angeschlossen ist, die Taktsignale waehlbarer Frequenz abgibt.

2. Vorrichtung gemaess Anspruch 1, dadurch gekennzeichnet, dass die Taktsignalquelle (31) an einen Rechner (29) angeschlossen ist.

3. Vorrichtung gemaess Anspruch 1, dadurch gekennzeichnet, dass das Filter durch einen Rechner (29) angesteuert ist.

4. Vorrichtung gemaess Anspruch 1, dadurch gekennzeichnet, dass das Filter geschaltete Kapazitaeten (44, 45) aufweist.

5. Vorrichtung gemaess Anspruch 1, dadurch gekennzeichnet, dass die Taktsignalquelle (31) an eine Signaleingabe (33) angeschlossen ist.

6. Vorrichtung gemaess Anspruch 4, dadurch gekennzeichnet, dass die Kapazitaeten (44, 45) an die Taktsignalquelle (31) angeschlossen sind.

7. Vorrichtung gemaess Anspruch 1, dadurch gekennzeichnet, dass die Taktsignalquelle (31) zur Abgabe zeitlich variabler Taktfrequenzen ausgebildet ist.

8. Vorrichtung gemaess Anspruch 1, dadurch gekennzeichnet, dass die Taktsignalquelle (31) an einen Speicher (66) angeschlossen ist.

9. Vorrichtung gemaess Anspruch 1, gekennzeichnet durch die Verwendung zur Digitalisierung physiologischer Messsignale.

Fig. 1

1/2

0214523

Fig.2

Fig.3

Fig.4